# EUROPEAN PATENT APPLICATION

(11) **EP 3 910 690 A1**
(43) Date of publication of application: **17.11.2021**
(21) Application number: 20174390.3
(22) Date of filing: 13.05.2020
(51) Int. Cl.: H01L 33/06, H01L 33/30, H01L 33/46, G02B 6/43

(54) **A NEUROMORPHIC DEVICE AND A NEURAL NETWORK SYSTEM**

(71) Applicant: INL - International Iberian Nanotechnology Laboratory, 4715-330 Braga (PT)
(72) Inventor: Romeira, Bruno Miguel Patarata, 4710-351 Braga (PT)
(74) Representative: AWA Sweden AB

(57) **Abstract**

The present invention relates to a neuromorphic device (10) and systems (30, 40) of at least two neuromorphic devices. The neuromorphic device (10) comprising: a semiconductor (100) nanostructure comprising: an emitter region (110), a collector region (120), a double-barrier quantum well region (130) having at least one resonance energy level, and a light-emitting region (140), wherein the double-barrier quantum well region (130) and the light-emitting region (140) are arranged in between the emitter region (110) and the collector region (120); a first contact (150) arranged in electrical contact with the emitter region (110); and a second contact (160) arranged in electrical contact with the collector region (120); and wherein charge carriers of the emitter region (110) are caused to tunnel through the double-barrier quantum well region (130) at a resonant energy level of the double-barrier quantum well region (130) in response to a voltage difference between the first contact (150) and the second contact (160) being within a predetermined voltage difference range; wherein a flow of charge carriers through the double-barrier quantum well region (130) and the light-emitting region (140) is formed in response to the charge carriers tunneling through the double-barrier quantum well region (130); and wherein the light-emitting region (140) is configured to emit light in response to the flow of charge carriers through the light-emitting region (140).

## Description

### Technical field

The present invention relates to a neuromorphic device and a neural network system comprising at least two neuromorphic devices.

### Background of the invention

Artificial intelligence (Al) systems using computing algorithms of deep learning neural networks are emerging rapidly. Despite the recent advancements within the field, the power budget involved in running deep learning neural networks in conventional computers is growing exponentially.

A type of current neural network systems is spiking neural networks (SNN) that uses artificial neuronal units that exchange information via spikes. An SNN uses the timing of the spikes to process information and each artificial neuron is typically only active when it receives or emits spikes. Such behavior reduces the required energy for operating the neural network. Neuromorphic hardware exhibiting a spiking behavior can be implemented using electronics, but then typically operates a low (kHz) speeds and requires several picojoule per spike.

A different type of upcoming neural networks includes photonic neural networks, and in order for such networks to function as a SNN, spiking photonic neurons have been implemented using graphene excitable lasers, distributed feedback lasers, or vertical-cavity surface-emitting lasers, to name a few. However, the footprint of such lasers is too large (> 100 µm²) for compact and efficient SNNs. An alternative is to use a light-emitting diode (LED), e.g. a nano-LED. However, LEDs typically also operate at slow speeds (MHz) since they rely on the spontaneous emission rate (about 2 ns).

Thus, there exists a need for efficient, fast, and miniaturized light-emitting sources suitable for brain-like photonic spike-based computing such as a neural network.

### Summary of the invention

It is an object of the present inventive concept to mitigate, alleviate or eliminate one or more of the above-identified deficiencies in the art and disadvantages singly or in any combination.

According to a first aspect a neuromorphic device is provided. The neuromorphic device comprising: a semiconductor nanostructure comprising: an emitter region, a collector region, a double-barrier quantum well region having at least one resonance energy level, and a light-emitting region, wherein the double-barrier quantum well region and the light-emitting region are arranged in between the emitter region and the collector region; a first contact arranged in electrical contact with the emitter region; and a second contact arranged in electrical contact with the collector region; and wherein charge carriers of the emitter region are caused to tunnel through the double-barrier quantum well region at a resonant energy level of the double-barrier quantum well region in response to a voltage difference between the first contact and the second contact being within a predetermined voltage difference range; wherein a flow of charge carriers through the double-barrier quantum well region and the light-emitting region is formed in response to the charge carriers tunneling through the double-barrier quantum well region; and wherein the light-emitting region is configured to emit light in response to the flow of charge carriers through the light-emitting region.

Since the double-barrier quantum well region of the neuromorphic device allows for resonant tunneling of charge carriers, it features a non-linear N-shaped current-voltage characteristic (I-V characteristic). With increasing voltage across the double-barrier quantum well region, the current through the double-barrier quantum well region initially increases until it reaches a peak, and then rapidly decreases until it reaches a valley. Further increasing the voltage, the current again starts to increase after the valley. This I-V characteristic allows the neuromorphic device to operate in a positive differential conductance (PDC) configuration or a negative differential conductance (NDC) configuration depending on an applied bias voltage (i.e. by applying a bias voltage corresponding to the valley or the peak). The bias voltage is applied between the first and second contacts of the neuromorphic device. More importantly, since the neuromorphic device also comprises a light-emitting region, the PDC and NDC configurations allow for a light output from the light-emitting region to increase (in PDC configuration) or decrease (in NDC configuration) in response to a relatively small increase in voltage. Thus, the neuromorphic device is therefore allowed to produce optical spikes that is similar to the pulse-like (spiking) dynamic behavior of biological neurons. Further, depending on the bias voltage applied to the neuromorphic device, the optical spikes reproduces the behavior of excitatory synapses and/or inhibitory synapses. Hence, the neuromorphic device is allowed to operate as an artificial neuron.

Since the neuromorphic device comprises the double-barrier quantum well region and the light-emitting region, it is further appreciated that losses (e.g., electrical and/or optical losses) related to electrical and/or optical connections between external units (e.g. a resonant tunneling diode comprising a double-barrier quantum well region connected to a light-emitting diode or laser) are reduced. It is also appreciated that the footprint of the neuromorphic device is reduced since the neuromorphic device comprises the double-barrier quantum well region and the light-emitting region within the same device.

The double-barrier quantum well region and the light-emitting region may be integrally formed.

An associated advantage is that a size of the neuromorphic device may be reduced. A further associated advantage is that a more power efficient device may be formed.

The double-barrier quantum well region and the light-emitting region may be arranged one after the other along a longitudinal direction of the semiconductor nanostructure.

An associated advantage is that the characteristics of the double-barrier quantum well region and the light-emitting region may be tailored independently, thereby allowing for an enhanced output of light from the neuromorphic device.

The double-barrier quantum well region may be an internal portion of the light-emitting region along a longitudinal direction of the semiconductor nanostructure.

An associated advantage is that a reduced energy dispersion of the emitted light may be allowed. Hence, an improved control of the light emission energy may be achieved.

The neuromorphic device may further comprise a resonant cavity enclosing the semiconductor nanostructure, wherein the resonant cavity may be configured to confine the light emitted by the light-emitting region.

By enclosing the semiconductor nanostructure in a resonant cavity, an enhanced emission of light from the light-emitting region may be promoted. This may be due to an enhancement of the spontaneous emission rate via the Purcell effect. The neuromorphic device may therefore be allowed to produce inhibitory and excitatory optical spikes at multi-GHz rate in response to a relatively small change in voltage.

One or more of the light-emitting region, the emitter region and the collector region may comprise a III-V semiconducting material and/or a nitride, e.g. III-N combinations.

The collector region may comprise a p-doped material and the emitter region may comprise an n-doped material, and the double-barrier quantum well region may be arranged in between the n-doped emitter region and the light-emitting region.

An associated advantage is that an electrical performance of the neuromorphic device may be determined mainly by electrons, and hole-tunneling into the light emitting region may be mitigated. Hence, the non-linear N-shaped I-V characteristic of the neuromorphic device may exhibit a more pronounced peak-to-valley ratio.

The p-doped material may comprise a first and a second p-doped layer, the first p-doped layer having a relatively higher degree of doping than the second p-doped layer, and the n-doped material may comprise a first and a second n-doped layer, the first n-doped layer having a relatively higher degree of doping than the second n-doped layer.

The double-barrier quantum well region may be configured such that the at least one resonance energy level corresponds to a Fermi level of the emitter region at a predetermined voltage difference between the first contact and the second contact, thereby providing a local maximum of a probability of charge carriers of the emitter region to tunnel through the double-barrier quantum well region.

By adjusting the bias voltage such that it corresponds to the predetermined voltage difference, the neuromorphic device may be allowed to operate in the NDC configuration, thereby allowing for the light emission from the light-emitting region to decrease in response to a relatively small voltage change between the first and second contacts.

The neuromorphic device may further comprise: an electrically isolating layer arranged between the nanostructure and the resonant cavity, wherein the electrically isolating layer may comprise throughputs allowing for the electrical contact between the first contact and the emitter region, and the second contact and the collector region.

By this arrangement electrical short-circuiting of the neuromorphic device may be prevented.

The emitter region and the collector region may comprise GaAs and/or InP.

Preferentially, the emitter region and the collector region may comprise the same material having different doping.

The double-barrier quantum well region may be formed by a stack of alternating layers comprising GaAs and AlAs.

The stack of alternating layers may be formed of a central layer comprising GaAs sandwiched between two intermediate layers comprising AlAs, the central layer and the two intermediate layers may be arranged between two outer layers comprising GaAs.

A size and/or material of the resonant cavity may be configured such that an evanescent field associated with light emitted by the light-emitting region may extend beyond an outer surface of the resonant cavity.

By configuring the resonant cavity such that an evanescent field extends beyond an outer surface of the resonant cavity, a further neuromorphic device may be arranged to receive the evanescent field as input. Two neuromorphic devices may thereby communicate and interact via the evanescent field.

One of the emitter region and collector region may comprise a light output portion, and wherein the resonant cavity may be configured such that light emitted from the light-emitting region may be predominantly conveyed to the light output portion, and the neuromorphic device may further comprise: a waveguide arranged to receive light from the light output portion, and to convey the received light to a light output region of the waveguide.

By configuring the resonant cavity such that the emitted light is conveyed to the light output portion of the waveguide, a further device (e.g. a light sensor) may be arranged at the light output portion of the waveguide to receive the emitted light as input. The emitted light may thereby be used and/or detected by the further device.

Said one of the emitter region and collector region may further comprise a light input portion configured to absorb light; and wherein the waveguide may be further configured to convey light from a light input region of the waveguide to the light input portion, thereby providing the voltage difference between the first contact and the second contact.

By the neuromorphic device comprising a light input portion configured to absorb light, the neuromorphic device may be allowed to absorb light as input which in turn allows the light-emitting region of the neuromorphic device to emit light. In other words, the absorbed light may result in a flow of charge carriers through the double-barrier quantum well region and the light-emitting region which in turn may result in light emission from the light-emitting region. The emitted light may, as described previously, then be conveyed to a light output portion of a waveguide. Thus, two or more neuromorphic device may thereby be allowed to communicate and interact.

The semiconductor nanostructure may be a nano-pillar, a nano-wire, a nano-whisker, a nano-rod, and/or a nano-column.

According to a second aspect, a neural network system is provided. The neural network system comprising: at least two neuromorphic devices according to the first aspect arranged such that the evanescent field associated with light emitted from a first neuromorphic device interacts with a material in the first contact and/or second contact of a second neuromorphic device, thereby resulting in a voltage difference between the first contact and the second contact of the second neuromorphic device.

The above-mentioned features of the first aspect, when applicable, apply to this second aspect as well. In order to avoid undue repetition, reference is made to the above.

According to a third aspect, a neural network system is provided. The neural network system comprising: at least two neuromorphic devices according to the first aspect arranged such that light conveyed to the light output region of a waveguide of a first neuromorphic device is conveyed to the light input region of a waveguide of a second neuromorphic device.

The above-mentioned features of the first aspect and the second aspect, when applicable, apply to this third aspect as well. In order to avoid undue repetition, reference is made to the above.

A further scope of applicability of the present disclosure will become apparent from the detailed description given below. However, it should be understood that the detailed description and specific examples, while indicating preferred variants of the present inventive concept, are given by way of illustration only, since various changes and modifications within the scope of the inventive concept will become apparent to those skilled in the art from this detailed description.

Hence, it is to be understood that this inventive concept is not limited to the particular steps of the methods described or component parts of the systems described as such method and system may vary. It is also to be understood that the terminology used herein is for purpose of describing particular embodiments only and is not intended to be limiting. It must be noted that, as used in the specification and the appended claim, the articles "a", "an", "the", and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings do not exclude other elements or steps.

### Brief description of the drawings

The above and other aspects of the present inventive concept will now be described in more detail, with reference to appended drawings showing variants of the invention. The figures should not be considered limiting the invention to the specific variant; instead they are used for explaining and understanding the inventive concept.

As illustrated in the figures, the sizes of layers and regions are exaggerated for illustrative purposes and, thus, are provided to illustrate the general structures of variants of the present inventive concept. Like reference numerals refer to like elements throughout.
Figure 1A illustrates a neuromorphic device comprising a semiconductor nanostructure in which the double-barrier quantum well region and the light-emitting region are arranged one after the other.
Figure 1B illustrates an alternative arrangement of the semiconductor nanostructure in which the double-barrier quantum well region is an internal portion of the light-emitting region.
Figure 1C illustrates the double-barrier quantum well region of Fig. 1A and Fig. 1B.
Figure 1D illustrates a bandgap structure of the double-barrier quantum well region of Fig. 1C.
Figure 2A illustrates an example of current-voltage characteristics of neuromorphic devices.
Figure 2B illustrates an example of optical output-voltage characteristics of neuromorphic devices.
Figure 2C illustrates example response behaviors of neuromorphic devices.
Figure 3A illustrates a first neural network system comprising two neuromorphic devices arranged to communicate via an evanescent field.
Figure 3B illustrates a second neural network system comprising two neuromorphic devices arranged to communicate via a waveguide.

### Detailed description

The present inventive concept will now be described more fully hereinafter with reference to the accompanying drawings, in which currently preferred variants of the inventive concept are shown. This inventive concept may, however, be implemented in many different forms and should not be construed as limited to the variants set forth herein; rather, these variants are provided for thoroughness and completeness, and fully convey the scope of the present inventive concept to the skilled person.

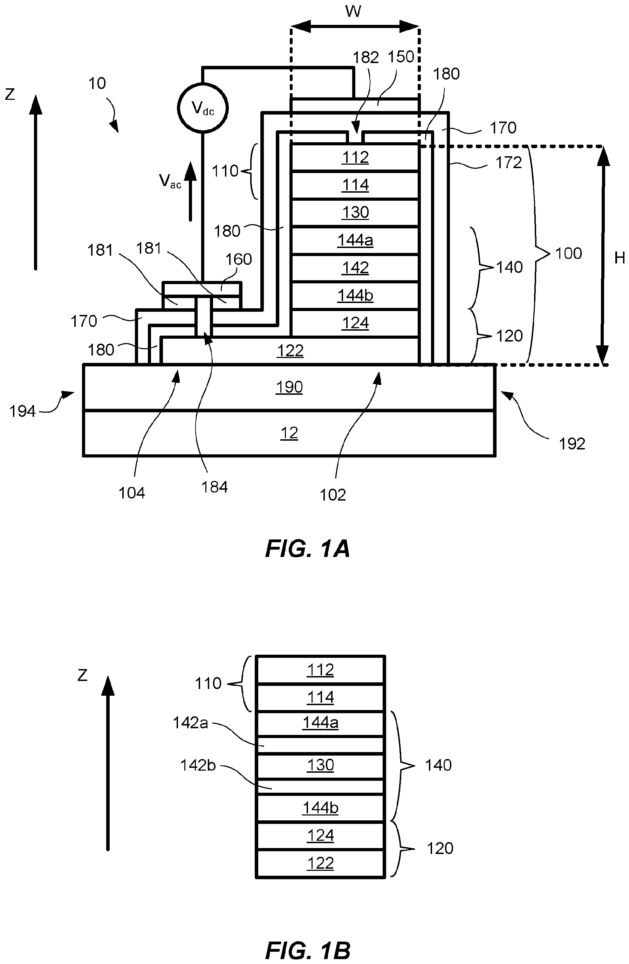

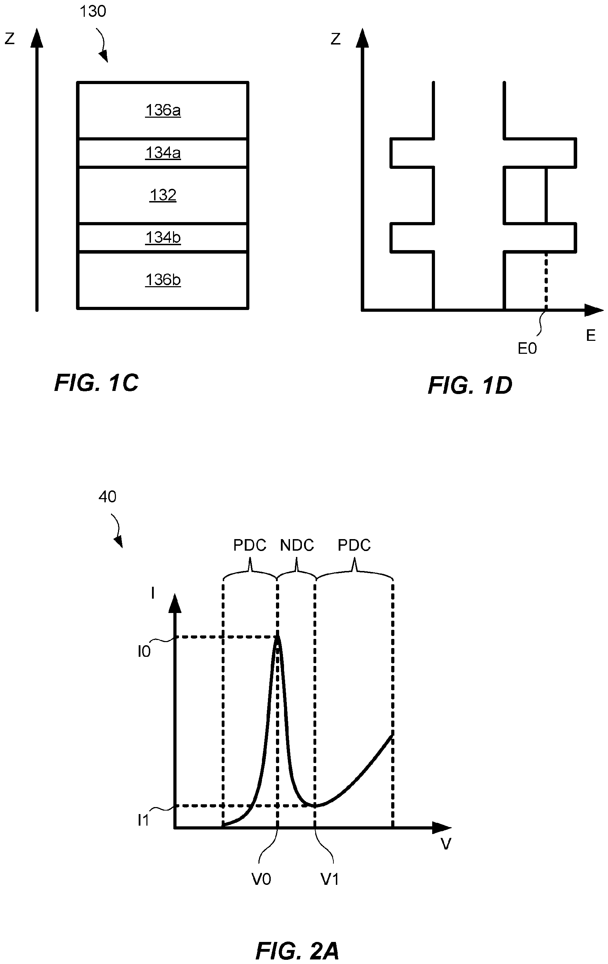

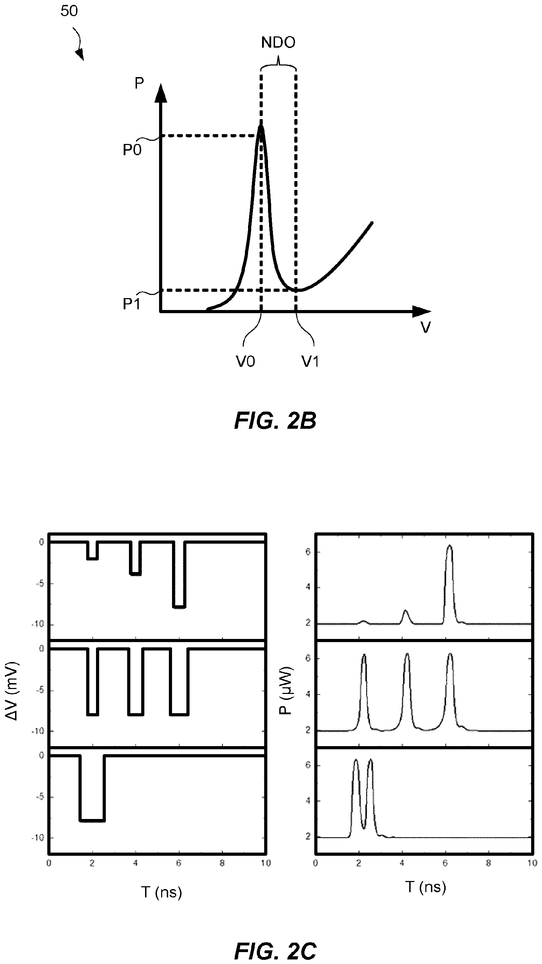

A neuromorphic device will now be described with reference to Fig. 1 and Fig. 2.

Figure 1A illustrates a neuromorphic device 10. The neuromorphic device 10 comprises a semiconductor nanostructure 100. The semiconductor nanostructure 100 may be a nano-pillar, a nano-wire, a nano-whisker, a nano-rod, and/or a nano-column. A width W of the semiconductor nanostructure may be in a range from 50 nm - 300 nm. A height H of the semiconductor nanostructure may be in a range from 100 nm - 1000 nm. The semiconductor nanostructure 100 may be formed as a mesa-structure. The neuromorphic device may be arranged on a substrate 12 as exemplified in Fig. 1A. The substrate may comprise SiO₂.

The semiconductor nanostructure 100 comprises an emitter region 110, a collector region 120, a double-barrier quantum well region 130, and a light-emitting region 140. One or more of the emitter region 110, the collector region 120, and the light-emitting region 140 may comprise a III-V semiconducting material and/or a nitride, e.g. III-N combinations. The emitter region 110 may have a thickness within a range from 100 - 200 nm. The collector region 120 may have a thickness within a range from 10 nm to 300 nm. The thickness of the collector region 120 may preferably be within a range from 50 nm to 150 nm. The thickness of the collector region 120 may more preferably be within a range from 50 nm to 100 nm. The double-barrier quantum well region 130 may have a thickness within a range from 15 nm - 30 nm. The light-emitting region 140 may have a thickness within a range from 50 nm to 350 nm. The thickness of the light-emitting region 140 may preferably be within a range from 100 nm to 250 nm. The double-barrier quantum well region 130 may be formed in an intrinsic (undoped) region of the semiconductor nanostructure 100, i.e. in an intrinsic region of a pn-junction.

The collector region 120 may comprise a p-doped material and the emitter region 110 may comprise an n-doped material. As exemplified in Fig. 1A, the p-doped collector region may comprise a first p-doped layer 122 and a second p-doped layer 124. The first p-doped layer 122 may have a relatively higher degree of doping than the second p-doped layer 124. Within the art, the first p-doped layer 122 may be referred to as a p⁺-doped layer and the second p-doped layer 124 may be referred to as a p⁻-doped layer. As shown in the example of Fig. 1A, the n-doped emitter region 110 may comprise a first n-doped layer 112 and a second n-doped layer 114. The first n-doped layer 122 may have a relatively higher degree of doping than the second n-doped layer 124. Within the art, the first n-doped layer 112 may be referred to as a n⁺-doped layer and the second n-doped layer 114 may be referred to as a n⁻-doped layer.

The emitter region 110 and the collector region 120 may comprise GaAs and/or InP. The emitter region 110 and the collector region 120 may comprise the same material with different doping.

The double-barrier quantum well region 130 has at least one resonance energy level E0. The resonance energy level E0 will be discussed in connection with Fig. 1D.

The double-barrier quantum well region 130 may be formed by a stack of alternating layers comprising GaAs and AlAs. Alternatively, the double-barrier quantum well region 130 may be formed by a stack of alternating layers comprising InP and InAs. In any case, a material of layers acting as barriers in the double-barrier quantum well region 130 may have a higher bandgap than a material of layers surrounding the layers acting as barriers, which is shown in the example of Fig. 1C and Fig. 1D. As shown in the example of Fig. 1C, the stack of alternating layers may be formed of a central layer 132 comprising GaAs sandwiched between two intermediate layers 134 comprising AlAs, the central layer 132 and the two intermediate layers 134 may be arranged between two outer layers 136 comprising GaAs. In the example of Fig. 1C, the central layer has a thickness of 6 nm, each of the two intermediate layers a thickness of 1.7 nm, and each of the two outer layers a thickness of 10 nm. It is to be understood that the dimensions (e.g. thicknesses and widths) of the layers illustrated in Fig. 1C are examples only. For example, the central layer 132 and the outer layers 136 are shown to be of equal thickness and widths, however they may be different. The thickness of the two intermediate layers 134 may furthermore have different thicknesses and/or widths. In Fig. 1D, a bandgap diagram of the double-barrier quantum well region 130 of Fig. 1C is illustrated.

The light-emitting region 140 may comprise a stack of layers. As is exemplified in Fig. 1A, the light-emitting region 140 may comprise a central layer 142 sandwiched between two outer layers 144. The central layer 142 of the light-emitting region 140 may comprise GaAs. The outer layers 144 of the light-emitting region 140 may comprise AIGaAs. The light-emitting region 140 may be a double heterostructure.

As is seen in the example of Fig. 1A, the double-barrier quantum well region 130 and the light-emitting region 140 are arranged in between the emitter region 110 and the collector region 120. The double-barrier quantum well region 130 and the light-emitting region 140 may be integrally formed. As shown in the example of Fig. 1A, the double-barrier quantum well region 130 and the light-emitting region 140 may be arranged one after the other along a longitudinal direction Z of the semiconductor nanostructure 100. Alternatively, as is shown in the example of Fig. 1B, the double-barrier quantum well region 130 may be an internal portion of the light-emitting region 140 along a longitudinal direction Z of the semiconductor nanostructure 100. Since the light-emitting region 140 may be an undoped region of the semiconductor nanostructure 100, the double-barrier quantum well region 130 may be formed as an internal portion of the light-emitting region 140. As is shown in the example of Fig. 1B, the double-barrier quantum well region 130 may be arranged in between two surrounding layers 142a, 142b of the light-emitting region 140.

Hence, in case the emitter region 110 comprises an n-doped material, the double-barrier quantum well region 130 may be arranged in between the n-doped emitter region 110 and the light-emitting region 140. The double-barrier quantum well region 130 may be within an undoped (intrinsic) region of the semiconductor nanostructure 100. Thus, an electrical performance of the neuromorphic device 10 may be determined mainly by electrons, and hole-tunneling into the light emitting region 140 may be mitigated. The non-linear N-shaped I-V characteristic of the neuromorphic device 10 may thereby exhibit a more pronounced peak-to-valley ratio (i.e. the peak I0 at voltage V0 and valley I1 at voltage V1 in Fig. 2A). In other words, since electron transport may be faster (i.e. higher mobility) and the minoritory hole concentration and hole diffusion will be reduced, the peak-to-valley ratio may be higher than when holes contribute to the flow of charge carriers.

The neuromorphic device 10 further comprises a first contact 150 arranged in electrical contact with the emitter region 110. The neuromorphic device 10 further comprises a second contact 160 arranged in electrical contact with the collector region 120. As is shown in Fig. 1A, a voltage difference V is applied between the first contact 150 and the second contact 160. The voltage difference V comprises a bias voltage V_{dc}.

Charge carriers of the emitter region 110 are caused to tunnel through the double-barrier quantum well region 130 at a resonant energy level of the double-barrier quantum well region 130 in response to a voltage difference V between the first contact 150 and the second contact 160 being within a predetermined voltage difference range. In case the charge carriers are electrons, a peak current density of the flow of charge carriers may be within a range from 10 kA/cm² - 100 kA/cm².

As indicated in Fig. 1D, the double-barrier quantum well region 130 has at least one resonance energy level E0. A probability for tunneling through the double-barrier quantum well region 130 for charge carriers having an energy corresponding to the at least one resonance energy level E0 may relatively speaking be high, resulting in a large current through the double-barrier quantum well region 130. Thus, a flow of charge carriers through the double-barrier quantum well region 130 and the light-emitting region 140 is formed in response to the charge carriers tunneling through the double-barrier quantum well region 130.

The light-emitting region 140 is configured to emit light in response to the flow of charge carriers through the light-emitting region 140. A central wavelength of the light emitted by the light-emitting region 140 may be determined by the materials and/or dimensions of the light-emitting region. Bulk GaAs may, e.g., target a light emission at approximately 850 nm. Depending on the target emission, other materials may be used, e.g. quantum wells or quantum dots. Since the double-barrier quantum well region 130 of the neuromorphic device 10 allows for resonant tunneling of charge carriers, it features a non-linear N-shaped current-voltage characteristic (I-V characteristic) which is described in connection to Fig. 2A.

The double-barrier quantum well region 130 may be configured such that the at least one resonance energy level E0 corresponds to a Fermi level of the emitter region 110 at a predetermined voltage difference between the first contact 150 and the second contact 160, thereby providing a local maximum of a probability of charge carriers of the emitter region 110 to tunnel through the double-barrier quantum well region 130. The local maximum of a probability of charge carriers of the emitter region 110 to tunnel through the double-barrier quantum well region 130 may result in a local maximum of the emitted light from the light-emitting region 140. By adjusting the bias voltage V_{dc} such that it corresponds to the predetermined voltage difference, the neuromorphic device 10 may thereby be allowed to operate in the NDC configuration, thereby allowing for the light emission from the light-emitting region 140 to decrease in response to a relatively small change in voltage between the first contact 150 and second contact 160. The small change in voltage may be a result of an incoming signal V_{ac} to the neuromorphic device 10. The incoming signal V_{ac} may be within a range from 10 mV to 100 mV. The incoming signal V_{ac} may hence be close to a shot-noise limit. The neuromorphic device 10 may thus be driven by noise (i.e. that the neuromorphic device 10 outputs optical pulses/optical spikes in response to input noise). The incoming signal V_{ac} may typically be within a range from 60 mV to 100 mV. Different ways in which an incoming signal V_{ac} may be coupled to the neuromorphic device 10 will be described later.

The double-barrier quantum well region 130 may be configured such that the Fermi level of the emitter region 110 is higher than the at least one resonance energy level E0 at a further predetermined voltage difference between the first contact 150 and the second contact 160, thereby providing a local minimum of the probability of charge carriers of the emitter region 110 to tunnel through the double-barrier quantum well region 130. The local minimum of the probability of charge carriers of the emitter region 110 to tunnel through the double-barrier quantum well region 130 may result in a local minimum of the emitted light from the light-emitting region 140. By adjusting the bias voltage V_{dc} such that it corresponds to the further predetermined voltage difference, the neuromorphic device 10 may thereby be allowed to operate in the PDC configuration, thereby allowing for the light emission from the light-emitting region 140 to increase in response to a relatively small change in voltage between the first contact 150 and second contact 160. The small change in voltage may be a result of an incoming signal V_{ac} to the neuromorphic device 10. Different ways in which an incoming signal V_{ac} may be coupled to the neuromorphic device 10 will be described later.

In other words, a bandgap structure of the double-barrier quantum well region 130 may shift in response to an applied voltage difference between the first contact 150 and the second contact 160, and the double-barrier quantum well region 130 may be configured such that the resonance energy level E0 corresponds to the Fermi level of the emitter region 110 at the predetermined voltage difference (i.e. the bias voltage V_{dc}) between the first contact 150 and the second contact 160. The predetermined voltage difference may be within the predetermined voltage difference range.

The neuromorphic device 10 may further comprise a resonant cavity 170 enclosing the semiconductor nanostructure 100. The resonant cavity 170 may be configured to confine the light emitted by the light-emitting region 140. The resonant cavity 170 may be a metal cavity. The metal cavity may comprise gold (Au). The metal cavity may reflect the light emitted by the light-emitting region 140. Alternatively, the resonant cavity 170 may be a dielectric cavity configured to concentrate the light emitted by the light-emitting region 140 inside the semiconductor nanostructure 100. A thickness of the resonant cavity may be within a range from 10 to 200 nm. In case the resonant cavity 170 is a metal cavity, the thickness of the resonant cavity 170 may be within a range from 10 nm to 50 nm. In case the resonant cavity 170 is a dielectric cavity, the thickness of the resonant cavity 170 may be within a range from 100 nm to 200 nm. By enclosing the semiconductor nanostructure 100 in a resonant cavity 170, an enhanced emission of light from the light-emitting region 140 may be allowed. This may be due to an enhancement of the spontaneous emission rate from the light-emitting region 140 via the Purcell effect. A further advantageous effect of enclosing the semiconductor nanostructure 100 in a resonant cavity 170 is that the temporal duration of the emitted light (i.e. an optical spike) may be shorter than 100 ps, since the bandwidth of the emitted light may be increased by the Purcell effect. The neuromorphic device 10 may therefore be allowed to produce inhibitory and excitatory optical spikes at multi-GHz rate in response to a relatively small change in voltage.

The neuromorphic device 10 may further comprise: an electrically isolating layer 180 arranged between the semiconductor nanostructure 100 and the resonant cavity 170. The electrically isolating layer 180 may comprise throughputs allowing for the electrical contact between the first contact 150 and the emitter region 110, and the second contact 160 and the collector region 120. A The neuromorphic device 10 may further comprise a further electrically isolating layer 181 arranged between the first contact 150 and/or the second contact 160 and the resonant cavity 170. This is exemplified in Fig. 1A by the further electrically isolating layer 181 arranged between the second contact 160 and the resonant cavity 170. The electrically isolating layer 180 and/or the further electrically isolating layer 181 may comprise silicon dioxide (SiO₂). A thickness of the electrically isolating layer 180 and/or the further electrically isolating layer 181 may be within a range from 10 nm to 300 nm. In case the resonant cavity 170 is a metal cavity, it may form a reflector in case the electrically isolating layer is thick or a plasmonic enhancer in case the electrically isolating layer is thin. In this context, "a thick electrically isolating layer" may have a thickness above 10 % to 20 % of a wavelength (e.g. a central wavelength) of the emitted light. Hence, "a thick electrically isolating layer" may have a thickness in a range from 100 nm and larger. In this context, "a thin electrically isolating layer" may have a thickness below 1 % of the wavelength (e.g. a central wavelength) of the emitted light. Hence, "a thin electrically isolating layer" may have a thickness smaller than or eqaul to 10 nm.

One of the emitter region 110 and collector region 120 may comprise a light output portion 102, and wherein the resonant cavity 170 may be configured such that light emitted from the light-emitting region 140 may be predominantly conveyed to the light output portion 102, and the neuromorphic device 10 may further comprise: a waveguide 190 arranged to receive light from the light output portion 102, and to convey the received light to a light output region 192 of the waveguide 190. A thickness of the waveguide 190 may be adapted such that the received light is conveyed within the waveguide 190. The waveguide 190 may comprise a core layer and a cladding layer. It is to be understood that the substrate 12 and the waveguide 190 may be integrally formed.

By configuring the resonant cavity 170 such that the light emitted by the light-emitting portion 140 is conveyed to the light output portion 192 of the waveguide 190, a further device 10 (e.g. a light sensor) may be arranged at the light output portion 192 of the waveguide 190 to receive the emitted light as input. The emitted light may thereby be used and/or detected by the further device.

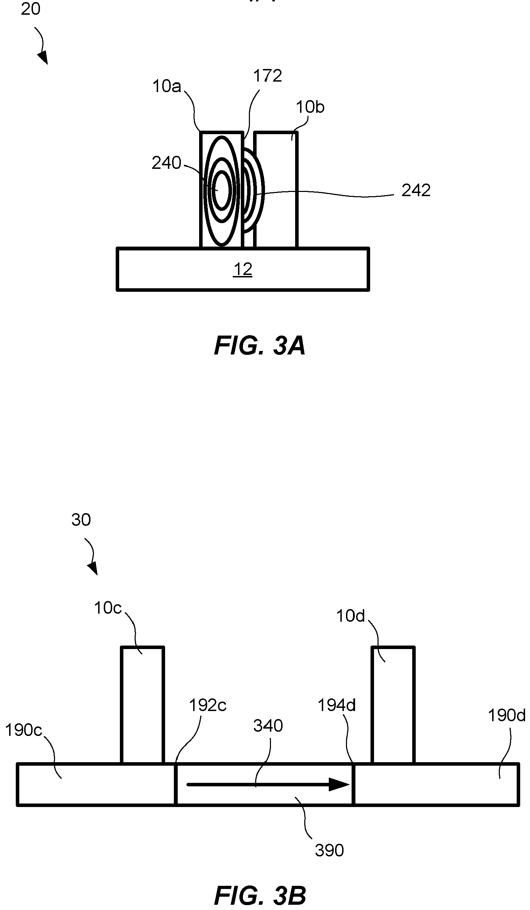

Said one of the emitter region 110 and collector region 120 may further comprise a light input portion 104 configured to absorb light. The waveguide 190 may be further configured to convey light from a light input region 194 of the waveguide 190 to the light input portion 104, thereby providing the voltage difference between the first contact 150 and the second contact 160. By the neuromorphic device 10 comprising a light input portion 104 configured to absorb light, the neuromorphic device 10 may be allowed to absorb light as input which in turn allows the light-emitting region 140 of the neuromorphic device 10 to emit light. The emitted light may, as described previously, then be conveyed to a light output portion 192 of a waveguide 190. Thus, two or more neuromorphic devices 10 may thereby be allowed to communicate via the waveguide 190, as will be described in connection to Fig. 3B.

A size and/or material of the resonant cavity 170 may be configured such that an evanescent field associated with light emitted by the light-emitting region 140 may extend beyond an outer surface of the resonant cavity 170. Further, a size and/or material of the electrically isolating layer 180 may be configured such that an evanescent field associated with light emitted by the light-emitting region 140 may extend beyond an outer surface of the resonant cavity 170. By configuring the resonant cavity 170 (and the electrically isolating layer 180, if present) such that an evanescent field extends beyond an outer surface of the resonant cavity 170, a further neuromorphic device 10 may be arranged to receive the evanescent field as input. Two neuromorphic devices 10 may thereby communicate via the evanescent field, as will be described in connection to Fig. 3A and Fig. 3B.

Figure 2A illustrates a schematic diagram 40 of the voltage-current (I-V) characteristic of the neuromorphic device 10. With increasing voltage V across the double-barrier quantum well region 130, the current I through the double-barrier quantum well region 130 initially increases until it reaches a peak current I0 at a first voltage V0, and then rapidly decreases until it reaches a valley. The current I passing through the double-barrier quantum well region 130 is I1 in the valley at a second voltage V1. Further increasing the voltage V, the current I through the double-barrier quantum well region 130 again starts to increase. This characteristics can be understood by studying the bandgap diagram of Fig. 1D. Without an applied voltage, the differences between the resonant energy level E0 of the double-barrier quantum well region 130 and the energies of the charge carriers are large, thereby resulting in a low tunneling probability whereby the flow of charge carriers (the current I) is low. Increasing the voltage, the bandgap structure starts to shift, and the differences between the resonant energy level E0 and the energies of the charge carriers start to decrease, thereby resulting in an increasing tunneling probability and an increasing flow of charge carriers through the double-barrier quantum well region 130. The voltage at which the neuromorphic device 10 starts to emit light may be a threshold or an activation voltage. At a point where the applied voltage is such that the energies of the charge carriers correspond to the resonant energy level E0 (i.e. at voltage V0 in Fig. 2A), the probability for tunneling has a maximum (due to the resonant tunneling of charge carriers through the double-barrier quantum well region 130), thereby resulting in a maximum flow of charge carriers. Further increasing the voltage again starts to increase the differences between the energies of the charge carriers and the resonant energy level E0, thus leading to a reduced tunneling probability and a reduced current. The applied voltage can be increased such that the bandgap structure is shifted to a degree such that the energies of the charge carriers in the emitter region 110 is above the energy of one of the barrier regions 134. In such case, the tunneling probability is increasing with increasing voltage, which is seen at the voltage V1 in Fig. 2A. At sufficiently high voltages, the bandgap structure is shifted to an extent such that the Fermi level is above both barrier regions 134, leading to a large flow of charge carriers. Thus, the double-barrier quantum well region 130 of the neuromorphic device 10 exhibits a non-linear N-shaped I-V characteristic as shown in Fig. 2A.

This I-V characteristic allows the neuromorphic device 10 to operate in positive differential conductance (PDC) configurations or a negative differential conductance (NDC) configuration depending on the applied bias voltage V_{dc} (i.e. by applying a bias voltage V_{dc} corresponding to the voltage corresponding to the valley or the peak). The bias voltage V_{dc} is applied between the first contact 150 and the second contact 160 of the neuromorphic device 10. More importantly, since the neuromorphic device 10 also comprises a light-emitting region 140, the PDC and NDC configurations allow for a light output from the light-emitting region 140 to increase (in the PDC configuration) or decrease (in the NDC configuration) in response to a relatively small increase in voltage V. This is shown in the optical output-voltage (P-V) characteristic shown illustrated in Fig. 2B. Thus, the neuromorphic device 10 is therefore allowed to produce optical spikes in response to a small increase in voltage. The small increase in voltage V may be a result of an incoming signal V_{ac} to the neuromorphic device 10. The input signal V_{ac} may, e.g., be a result of the absorption of an incoming optical pulse and/or the coupling of an evanescent field from a different neuromorphic device 10, which is described in connection to Fig. 3A and Fig. 3B. The input signal V_{ac} may be within a range from 10 mV to 100 mV. The incoming signal V_{ac} may typically be within a range from 60 mV to 100 mV. Hence, an input signal V_{ac} causing the neuromorphic device 10 to output optical spikes may be within a range from 10 mV to 100 mV.

Now, according to Fig. 2A and Fig. 2B, operating the neuromorphic device 10 at a bias voltage V_{dc} corresponding to the first voltage V0 (i.e. at the boundary between the PDC and NDC configurations), a current I0 passes through the semiconductor nanostructure 100 and the light-emitting region 140 thereby emits light with an output power P0. As is seen in Fig. 2B, a small change in the voltage V would abruptly decrease the power P of the emitted light. Thus, in this configuration, the neuromorphic device 10 is functioning similar to an inhibitory synapse in that the neuromorphic device 10 is constantly firing (i.e. emitting light), and in response to an input (i.e. a small voltage drop) the current flow is abruptly decreased which will be seen as an abrupt decrease in the emitted light.

If the neuromorphic device 10 instead is operated at a bias voltage V_{dc} corresponding to the second voltage V1, a current I1 passes through the semiconductor nanostructure 100 and the light-emitting region 140 thereby emits light with an output power P1. In this case, a small decrease in the voltage V would abruptly increase the power P of the emitted light. Thus, in this configuration, the neuromorphic device 10 is functioning similar to an excitatory synapse in that the neuromorphic device 10 is constantly emitting light at a relatively low level, and in response to an input (i.e. a small voltage drop) the current flow is abruptly increased which will be seen as an abrupt increase in the emitted light (i.e. as an optical spike). This spiking behavior is similar to that of biological neurons, i.e. that the device reacts strongly to a weak input. In other words, depending on the applied bias voltage V_{dc}, the neuromorphic device 10 may function as an inhibitory artificial neuron or as an excitatory artificial neuron.

Turning to Fig. 2C which illustrates the output power of light emitted by the neuromorphic device 10 operating at the second voltage V1 (i.e. in the valley) in response to voltage drops ΔV. In other words, Fig. 2C illustrates the output power of light emitted by the neuromorphic device 10 operating as an excitatory artificial neuron. In this example, the neuromorphic device 10 is constantly emitting light having a power of approximately 2 µW, and in response to the voltage drops the neuromorphic device 10 emits optical spikes. The temporal duration of each optical spike may be within a range from 10 ps - 1 ns. An energy of each optical spike may be within a range from 1 fJ - 10 fJ. A voltage drop ΔV here may be due to an incoming signal V_{ac}. On the left-hand side of Fig. 2C, different voltage drops ΔV (e.g. resulted from input signals V_{ac}) are illustrated, and on the right-hand side the corresponding output power P of light emitted by the neuromorphic device 10 are illustrated.

In the top row of Fig. 2C, three different voltage drops ΔV with linearly decreasing amplitude is shown, however the corresponding output power P of the emitted light increases exponentially. Hence, the output powers P increase exponentially with linearly decreasing voltage drops ΔV, which can be realized when studying the steep slope of the NDO region of Fig. 2B.

In the middle row of Fig. 2C, three different voltage drops ΔV with increasing temporal duration is shown, however temporal durations of the corresponding emitted light remain substantially constant. Hence, the temporal durations of the emitted light remain substantially constant increasing temporal duration of the voltage drops ΔV. However, if the temporal duration of the voltage drop ΔV is sufficiently long, the neuromorphic device 10 will emit two optical pulses, as illustrated in the bottom row of Fig. 2C. This is an effect of a refractory period of the neuromorphic device 10. An excitable system, such as the neuromorphic device 10, may provide a large response to a small input (in this case the emission of light in response to a small voltage change) followed by a lapse (i.e. the refractory time) during which the system (i.e. the neuromorphic device 10) does not respond to new stimuli. The refractory period of the neuromorphic device 10 may be limited by the particular materials and/or construction of the neuromorphic device 10. The refractory period of the neuromorphic device 10 may be limited by the switch on-off time of the resonant tunneling escape time in the double-barrier quantum well region 130, which typically is on the picosecond timescale. Hence, in case the temporal duration of the voltage drop ΔV (as is the case for the bottom row of Fig. 2C) is longer than the refractory period, the neuromorphic device 10 provides two optical pulses in response to a single input signal. In this way, the neuromorphic device 10 may be allowed to produce excitatory optical spikes (pulses) or inhibitory optical spikes (pulses), depending on the applied bias voltage V_{dc}, in response to a small increase in voltage.

The behavior of the neuromorphic device 10 as illustrated in Fig. 2C is similar to the behavior of biological neurons. Hence, the neuromorphic device 10 is thereby designed to function as an artificial neuron replicating the behavior of biological neurons.

Figure 3A is a schematic illustration of a first neural network system 20. The first neural network system 20 comprises at least two neuromorphic devices 10. In the example of Fig. 3A, only two neuromorphic devices 10a, 10b arranged on a substrate 12 are illustrated, however, it is understood that the first neural network system 20 may comprise more than two neuromorphic devices 10. Further, each of the neuromorphic devices 10 in the example of Fig. 3A, comprises a resonant cavity 170, and a size/dimensions and/or material of the resonant cavity is configured such that an evanescent field associated with light emitted by the light-emitting region 140 extends beyond an outer surface 172 of the resonant cavity 170.

The neuromorphic devices 10 are arranged such that the evanescent field 242 associated with light emitted 240 from a first neuromorphic device 10a interacts with a material in the first contact 150 and/or second contact 160 of a second neuromorphic device 10b, thereby resulting in a voltage difference V between the first contact 150 and the second contact 160 of the second neuromorphic device 10b. Hence, the first neuromorphic device 10a is allowed to communicate with the second neuromorphic device 10b via the evanescent field 242, and the second neuromorphic device 10b may react in response to the signal (i.e. evanescent field 242) emitted from the first neuromorphic device 10a.

Figure 3B is a schematic illustration of a second neural network system 30. The second neural network system 30 comprises two neuromorphic devices 10. In the example of Fig. 3B, only two neuromorphic devices 10c, 10d are illustrated, however, it is understood that the second neural network system 30 may comprise more than two neuromorphic devices 10. Further, each of the neuromorphic devices 10 in the example of Fig. 3B, comprises a resonant cavity 170 and a waveguide 190. Each neuromorphic device 10 is arranged on the waveguide 190. The resonant cavity 170 of first neuromorphic device 10c is configured such that light emitted from the light-emitting region 140 of the first neuromorphic device 10c is predominantly conveyed to a light output region 192c of the waveguide 190c. The second neuromorphic device 10d comprises a light input portion 104 configured to absorb light, and the waveguide 190d is configured to convey light from a light input region 194c of the waveguide 190 to the light input portion 104, thereby providing the voltage difference between the first contact 150 and the second contact 160 of the second neuromorphic device 10d.

In the second neural network system 30, first neuromorphic device 10c and the second neuromorphic device 10d are arranged such that light conveyed to the light output region 192c of the waveguide 190c of the first neuromorphic device 10c is conveyed to the light input region 194d of the waveguide 190d of the second neuromorphic device 10d. Hence, the first neuromorphic device 10c is allowed to communicate with the second neuromorphic device 10d via the waveguides 190c, 190d. In the example of Fig. 3B, a further waveguide 390 is illustrated. The further waveguide 390 may, as exemplified in Fig. 3B, be configured to convey light exiting the light output portion 192c to the light input portion 194d. It is further to be understood that the waveguide 190c of the first neuromorphic device 10c, the waveguide 190d of the second neuromorphic device 10d, and the further waveguide 390 may be sections of a same waveguide.

Hence, the first and second neural network systems 20, 30 shown in Fig. 3A and Fig. 3B may propagate a signal, and by increasing the number of individual neuromorphic devices 10 (i.e. artificial neurons), the systems 20, 30 may be allowed to replicate the behavior/functions of biological systems of neurons. In such case, a network of, e.g., waveguides 190 and/or positions of the neuromorphic devices 10 on the substrates 12 may be configured to promote communication between certain neuromorphic devices 10 or regions with neuromorphic devices 10.

If desired, an input (e.g. an initial input signal V_{ac}) to a neuromorphic device 10 of the first and/or the second neural network systems 20, 30 may be noise (since a smallest input signal V_{ac} may be close to 10 mV). Hence, the first and the second neural network systems 20, 30 may be allowed to mimic biological systems.

The person skilled in the art realizes that the present inventive concept by no means is limited to the preferred variants described above. On the contrary, many modifications and variations are possible within the scope of the appended claims. Additionally, variations to the disclosed variants can be understood and effected by the skilled person in practicing the claimed invention, from a study of the drawings, the disclosure, and the appended claims.

## Claims

1. A neuromorphic device (10) comprising:
a semiconductor (100) nanostructure comprising:
an emitter region (110),
a collector region (120),
a double-barrier quantum well region (130) having at least one resonance energy level, and
a light-emitting region (140),
wherein the double-barrier quantum well region (130) and the light-emitting region (140) are arranged in between the emitter region (110) and the collector region (120);
a first contact (150) arranged in electrical contact with the emitter region (110); and
a second contact (160) arranged in electrical contact with the collector region (120); and
wherein charge carriers of the emitter region (110) are caused to tunnel through the double-barrier quantum well region (130) at a resonant energy level of the double-barrier quantum well region (130) in response to a voltage difference between the first contact (150) and the second contact (160) being within a predetermined voltage difference range;
wherein a flow of charge carriers through the double-barrier quantum well region (130) and the light-emitting region (140) is formed in response to the charge carriers tunneling through the double-barrier quantum well region (130); and
wherein the light-emitting region (140) is configured to emit light in response to the flow of charge carriers through the light-emitting region (140).

2. The neuromorphic device (10) according to claim 1, wherein the double-barrier quantum well region (130) and the light-emitting region (140) are integrally formed.

3. The neuromorphic device (10) according to claim 1 or 2, wherein the double-barrier quantum well region (130) and the light-emitting region (140) are arranged one after the other along a longitudinal direction of the semiconductor nanostructure (100).

4. The neuromorphic device (10) according to claim 1 or 2, wherein the double-barrier quantum well region (130) is an internal portion of the light-emitting region (140) along a longitudinal direction of the semiconductor nanostructure (100).

5. The neuromorphic device (10) according to any preceding claim, further comprising a resonant cavity (170) enclosing the semiconductor nanostructure (100), wherein the resonant cavity (170) is configured to confine the light emitted by the light-emitting region (140).

6. The neuromorphic device (10) according to any preceding claim, wherein the collector region (120) comprises a p-doped material and the emitter region (110) comprises an n-doped material, and wherein the double-barrier quantum well region (130) is arranged in between the n-doped emitter region (110) and the light-emitting region (140).

7. The neuromorphic device (10) according to any preceding claim, wherein the double-barrier quantum well region (130) is configured such that the at least one resonance energy level corresponds to a Fermi level of the emitter region at a predetermined voltage difference between the first contact (150) and the second contact (160), thereby providing a local maximum of a probability of charge carriers of the emitter region (110) to tunnel through the double-barrier quantum well region (130).

8. The neuromorphic device (10) according to any one of claim 5 -7, further comprising:
an electrically isolating layer (180) arranged between the semiconductor nanostructure (100) and the resonant cavity, wherein the electrically isolating layer (180) comprises throughputs (182, 184) allowing for the electrical contact between the first contact (150) and the emitter region (110), and the second contact (160) and the collector region (120).

9. The neuromorphic device (10) according to any preceding claim, wherein the emitter region (110) and the collector region (120) comprises GaAs and/or InP.

10. The neuromorphic device (10) according to any preceding claim, wherein the double-barrier quantum well region (130) is formed by a stack of alternating layers comprising GaAs and AlAs.

11. The neuromorphic device (10) according to claim 10, wherein the stack of alternating layers is formed of a central layer (132) comprising GaAs sandwiched between two intermediate layers (134) comprising AlAs, the central layer (132) and the two intermediate layers (134) being arranged between two outer layers (136) comprising GaAs.

12. The neuromorphic device (10) according to any one of claims 5-11, wherein a size and/or material of the resonant cavity (170) is configured such that an evanescent field associated with light emitted by the light-emitting region (140) extends beyond an outer surface (172) of the resonant cavity (170).

13. The neuromorphic device (10) according to any one of claims 5-11, wherein one of the emitter region (110) and collector region (120) comprises a light output portion (102), and wherein the resonant cavity (170) is configured such that light emitted from the light-emitting region (140) is predominantly conveyed to the light output portion (102), the neuromorphic device (10) further comprising:
a waveguide (190) arranged to receive light from the light output portion (102), and to convey the received light to a light output region (192) of the waveguide (190).

14. The neuromorphic device (10) according to claim 13, wherein said one of the emitter region (110) and collector region (120) further comprises a light input portion (104) configured to absorb light; and
wherein the waveguide (190) is further configured to convey light from a light input region (194) of the waveguide (190) to the light input portion (104), thereby providing the voltage difference between the first contact (150) and the second contact (160).

15. A neural network system (20) comprising:
at least two neuromorphic devices (10a, 10b) according to claim 12 arranged such that the evanescent field (242) associated with light (240) emitted from a first neuromorphic device (10a) interacts with a material in the first contact (150) and/or second contact (160) of a second neuromorphic device (10b), thereby resulting in a voltage difference between the first contact (150) and the second contact (160) of the second neuromorphic device (10b).

16. A neural network system comprising:
at least two neuromorphic devices (10c, 10d) according to claim 14 arranged such that light conveyed to the light output region (192c) of a waveguide (190c) of a first neuromorphic device (10c) is conveyed to the light input region (194d) of a waveguide (190d) of a second neuromorphic device (10d).
